# EUROPEAN PATENT APPLICATION

(11) **EP 2 757 083 A1**
(43) Date of publication of application: **23.07.2014**
(21) Application number: 12831423.4
(22) Date of filing: 30.08.2012
(51) Int. Cl.: C04B 35/443, H01L 21/3065

(54) **MAGNESIUM ALUMINATE-BASED SINTERED BODY AND MEMBER FOR USE IN SEMICONDUCTOR MANUFACTURING DEVICES**

(30) Priority: 14.09.2011 JP 2011200721
(71) Applicant: Kyocera Corporation, Kyoto-shi Kyoto 612-8501 (JP)
(72) Inventor: TANAKA,Yasuhiro, Kyoto-shi Kyoto 612-8501 (JP)
(74) Representative: Viering, Jentschura & Partner Patent- und Rechtsanwälte
(86) International application number: PCT/JP2012/071995
(87) International publication number: WO 2013/038916

(57) **Abstract**

[Problem] To provide a dense, high-strength magnesium aluminate-based sintered body with excellent corrosion resistance to halogen-based corrosive gases and plasmas thereof, and to provide a member for use in semiconductor manufacturing devices. [Solution] This magnesium aluminate-based sintered body contains magnesium aluminate as the main crystal phase, and, relative to the total mass (with the content of all constituent components expressed in terms of oxides), the total content of Zn and K (converted to ZnO and K20, respectively) is 30-500ppm. Further, by forming this member for use in semiconductor manufacturing devices from the aforementioned magnesium aluminate-based sintered body, said member can be used over a long period of time, and manufacturing costs member can be reduced.

## Description

### TECHNICAL FIELD

The present invention relates to a magnesium aluminate-based sintered body and a member of a semiconductor manufacturing apparatus.

### BACKGROUND ART

Halogen-based corrosive gas plasmas, such as those of fluorine, chlorine, and bromine, are conventionally used in semiconductor manufacturing processes for vapor-phase growth, etching, cleaning, or the like because these plasmas are highly reactive.

The members of semiconductor manufacturing apparatuses that will be exposed to halogen-based corrosive gases or their plasmas must be resistant to corrosion and be dense and strong. For example, PTL 1 proposes a magnesium aluminate-based sintered body as such a member. This magnesium aluminate-based sintered body mainly contains MgAl₂O₄, and further contains at least one compound selected from the group consisting of rare-earth metal oxides and complex oxides containing a rare-earth element and any other metal element.

### CITATION LIST

### PATENT LITERATURE

PTL 1: Japanese Unexamined Patent Application Publication 6-40765

### SUMMARY OF INVENTION

### TECHNICAL PROBLEM

Unfortunately, rare-earth elements are unstable in supply because of increase in price due to increase in demand and uneven distribution of their resources. Accordingly, dense, strong and corrosion-resistant members not containing rare-earth elements are desired.

The present invention is intended to satisfy this desire, and an object of the invention is to provide a dense and strong magnesium aluminate-based sintered body corrosion-resistant to halogen-based corrosive gases or their plasmas, and a semiconductor manufacturing apparatus member made of the magnesium aluminate-based sintered body.

### SOLUTION TO PROBLEM

A magnesium aluminate-based sintered body according to the present invention contains magnesium aluminate as a main crystal phase, and Zn and K, wherein the sum of Zn content in terms of ZnO and K content in terms of K₂O is in a range of 30 ppm to 500 ppm relative to a total mass of oxides calculated from contents of all constituents.

A semiconductor manufacturing apparatus member according to the present invention is composed of the above-mentioned magnesium aluminate-based sintered body.

### ADVANTAGEOUS EFFECTS OF INVENTION

The magnesium aluminate-based sintered body according to the present invention contains magnesium aluminate as a main crystal phase, and Zn and K, wherein the sum of Zn content in terms of ZnO and K content in terms of K₂O is in a range of 30 ppm to 500 ppm relative to a total mass of oxides calculated from contents of all constituents, and therefore can be good in corrosion resistance to halogen-based corrosive gases and their plasmas, and can be dense and have high strength.

Also, since the semiconductor manufacturing apparatus member according to the present invention is composed of the above-described magnesium aluminate-based sintered body, it is good in resistance to corrosion, and is dense and have high strength, and accordingly can be used for a long time, reduce a number of times of replacement and the suspension time of the apparatus, thereby reducing cost in semiconductor manufacture.

### BRIEF DESCRIPTION OF DRAWINGS

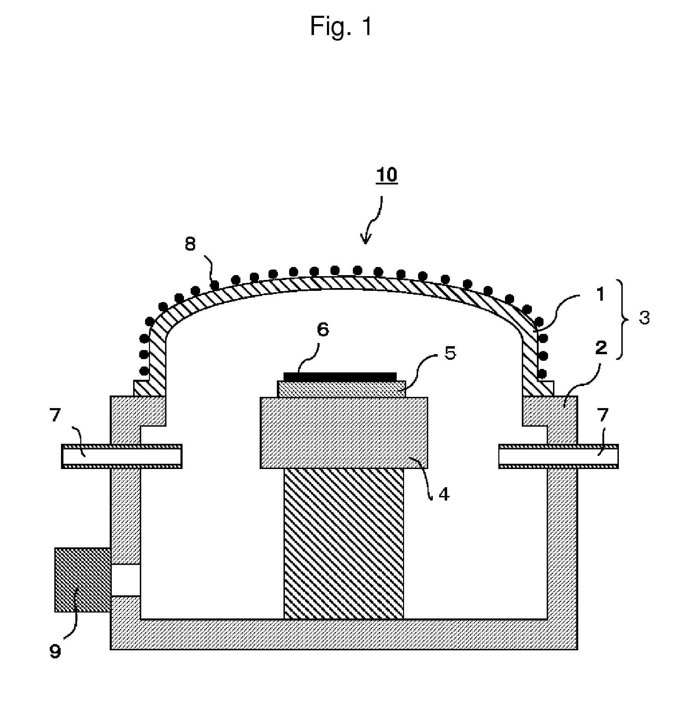

Fig. 1 is a schematic sectional view of an inductively coupled plasma treatment apparatus including a semiconductor apparatus member made of a magnesium aluminate-based sintered body according to an embodiment of the invention.

### DESCRIPTION OF EMBODIMENTS

An embodiment of the magnesium aluminate-based sintered body according to the present embodiment will now be described.

The magnesium aluminate-based sintered body according to the present embodiment contains magnesium aluminate (for example, MgAl₂O₄) as a main crystal phase, and Zn and K, wherein a sum of Zn content in terms of ZnO and K content in terms of K₂O is in a range of 30 ppm to 500 ppm relative to a total mass of oxides calculated from contents of all constituents.

When magnesium aluminate forms a main crystal phase of the sintered body, as described above, the sintered body exhibits high corrosion resistance to halogen-based corrosive gases and their plasmas (hereinafter simply referred to as corrosion resistance in some cases). In addition, when the sum of the Zn content in terms of ZnO and the K content in terms of K₂O is in the range of 30 ppm to 500 ppm relative to the total mass of oxides calculated from the contents of all constituents, in the magnesium aluminate-sintered body of the present embodiment, the strength of the magnesium aluminate-sintered body can be increased.

Although it is not clear why the strength of the magnesium aluminate-based sintered body can be increased when the sum of the Zn content in terms of ZnO and the K content in terms of K₂O is in the range of 30 ppm to 500 ppm, the present inventors think that such conditions suppress the grain growth of magnesium aluminate crystals of the main crystal phase, thereby densifying the crystal structure of the magnesium aluminate-based sintered body. The magnesium aluminate-based sintered body of the present embodiment has a density, which represents the degree of densification, of 3.48 g/cm³ or more. The density can be measured in accordance with JIS R1634-1998.

When Zn or K is independently contained, or when the sum of the Zn content in terms of ZnO and the K content in terms of K₂O is less than 30 ppm, their effect of increasing the strength is small. When the sum of the Zn content in terms of ZnO and the K content in terms of K₂O exceeds 500 ppm, corrosion resistance is reduced in comparison with the case where the sum of the Zn content in terms of ZnO and the K content in terms of K₂O is in the range of 30 ppm to 500 ppm.

Also, it is preferable that the sum of the Mg content in terms of MgO and the Al content in terms of Al₂O₃ in the magnesium aluminate (for example, MgAl₂O₄) of the main crystal phase be 99.7% by mass or more relative to the sum of oxides, 100% by mass, calculated from the contents of all constituents. Such a magnesium aluminate-based sintered body tends to exhibit higher corrosion resistance.

Although the magnesium aluminate-based sintered body of the present embodiment is superior in corrosion resistance to halogen-based corrosive gases or their plasmas and is dense and strong even without containing rare-earth elements, it goes without saying that it may contain rare-earth elements depending on the required corrosion resistance, strength, or the like.

The magnesium aluminate-based sintered body of the present embodiment may contain inevitable impurities deriving from the raw materials, and the term all constituents include inevitable impurities.

The main crystal phase mentioned in the present embodiment refers to the phase having the largest volume proportion of the crystal phases of the sintered body. It can be checked using area as below whether it is the main crystal or not. For example, the sintered body is subjected to polishing as pretreatment, and then the picture of an area of, for example, 100 µm x 100 µm is taken at a desired magnification through a metallurgical microscope, a SEM (Scanning Electron Microscope), an EPMA (Electron Probe Micro Analyzer) or the like. The taken picture is analyzed by an image analyzer, and a crystal phase accounting for more than 50% of the area is defined as the main crystal phase.

The image analyzer may be, for example, LUZEX-FS manufactured by Nireco. For identification of crystals, data obtained by, for example, X-ray diffraction or TEM electron diffraction may be compared with JCPDS card data. If X-ray diffraction does not show any large peaks except the peak of magnesium aluminate (for example, MgAl₂O₄), the magnesium aluminate can be considered to be the main crystal phase.

For determining the content of each constituent in terms of the corresponding oxide in the magnesium aluminate-based sintered body, part of the magnesium aluminate-based sintered body may be pulverized into powder and dissolved in a solvent such as hydrochloric acid, and the solution may be subjected to measurement with ICP (Inductively Coupled Plasma) emission spectrophotometer (for example, ICPS-8100 manufactured by Shimadzu Corporation). The thus obtained metal content is calculated into the content in terms of the corresponding oxide.

For the corrosion resistance of the magnesium aluminate-based sintered body, a sample of, for example, 10 mm in length by 10 mm in width by 1 mm in thickness is prepared, and is set in a RIE (Reactive Ion Etching) apparatus with the surface thereof partially masked. Subsequently, a test is performed by exposing the surface of the sample to plasma for several hours in a CF₄ gas atmosphere. Then, the level difference between the surface exposed to the plasma and the surface protected by the mask from the plasma exposure is measured with a surface roughness meter. The obtained level difference is compared with the level difference of an alumina-based sintered body tested under the same conditions and the relative value of comparison is evaluated as the etching rate ratio of the sample to the alumina-based sintered body, whose level difference is defined as 1.

The strength of the magnesium aluminate-based sintered body can be measured in accordance with the three-point flexural strength test specified in JIS R 1601-1995.

Although the magnesium aluminate forming the main crystal phase of the magnesium aluminate-based sintered body of the present embodiment may contain MgO and Al₂O₃ in a stoichiometric ratio of 1:1 on a mole basis and 28.6:71.4 on a mass basis, the ratio of MgO to Al₂O₃ in the magnesium aluminate is preferably in the range of 28.6-30.0:71.4-70.0 on a mass basis because when the MgO ratio is higher than the stoichiometric value, the corrosion resistance tends to increase.

Furthermore, in the magnesium aluminate-based sintered body of the present embodiment, the sum of the Si content in terms of SiO₂, the Ca content in terms of CaO and the P content in terms of P₂O₅ is preferably in the range of 500 ppm to 2500 ppm.

When the sum of the Si content in terms of SiO₂, the Ca content in terms of CaO and the P content in terms of P₂O₅ is in the range of 500 ppm to 2500 ppm, the degree of sintering increases and the crystal growth of magnesium aluminate of the main crystal phase is suppressed. Accordingly, the density of the magnesium aluminate-based sintered body increases. Since the density of the magnesium aluminate-based sintered body can be increased by increasing the degree of sintering and suppressing grain growth, sintering temperature can be reduced for forming the magnesium aluminate-based sintered body having the same density as a magnesium aluminate-based sintered body not containing Si, Ca or P. This leads to reduced manufacturing cost. If the magnesium aluminate-based sintered body contains Ca, it is preferable that grain boundaries do not contain CaAl₂O₄. When grain boundaries do not contain CaAl₂O₄, mechanical properties tend to be kept high. When the ratio of Al₂O₃ to MgO in the magnesium aluminate of the main crystal phase is lower than the stoichiometric mole ratio, CaAl₂O₄ tends to be less present in grain boundaries. More specifically, when the Al₂O₃ content is less than 71.4% by mass relative to 100% by mass of MgAl₂O₄, CaAl₂O₄ tends to be less present in grain boundaries.

Preferably, the magnesium aluminate-based sintered body of the present embodiment contains 3d transition metal oxides and the 3d transition metal oxide content in the surface portion thereof is lower than that in the interior thereof.

The surface portion mentioned herein refers to the portion at the vicinity of the surface of the magnesium aluminate-based sintered body, including the surface, and the interior refers to a portion inward from the vicinity of the surface of the magnesium aluminate-based sintered body in the thickness direction. More specifically, for a substrate of the magnesium aluminate-based sintered body having a thickness of 10 mm, the surface portion is the portion from the surface to a depth of 3 mm in the thickness direction, and the interior is a portion at a depth of more than 3 mm from the surface in the thickness direction.

The 3d transition metal oxide content can be determined by measuring samples taken from portions of the magnesium aluminate-based sintered body corresponding to the surface portion and the interior with an ICP emission spectrophotometer (for example, ICPS-8100 manufactured by Shimadzu Corporation). When a surface analyzer, such as EPMA, is used for measurement, the surface of the magnesium aluminate-based sintered body is pretreated for measurement by being polished to a depth of several micrometers, and the polished surface and the portion of a section perpendicular to the surface at a depth of more than 3 mm from the surface may be measured as the surface portion and the interior, respectively. For comparison between the surface portion and the interior, it is preferable that arbitrarily selected several points (3 to 5 points, for example,) are measured, and thus the average content is evaluated.

The 3d transition metal elements are elements of atomic numbers 22 to 29: titanium (Ti), vanadium (V), chromium (Cr), manganese (Mn), iron (Fe), cobalt (Co), nickel (Ni), and copper (Cu).

In production of the magnesium aluminate-based sintered body of the present embodiment, if any 3d transition metal oxide is contained, the degree of sintering can be increased to densify the sintered body. However, if a magnesium aluminate-based sintered body containing 3d transition metal oxides is used as a member of a semiconductor manufacturing apparatus, the 3d transition metal oxides tend to be altered into particles by being exposed to a halogen-based corrosive gas or its plasma. Therefore, from the viewpoint of increasing the degree of sintering to densify the sintered body, and, in addition, reducing the generation of particles, the 3d transition metal oxide content in the surface portion is preferably lower than that in the interior.

Particularly preferably, the 3d transition metal oxide content in the surface portion is 1/4 or less of the 3d transition metal oxide content in the interior. When the 3d transition metal oxide content in the surface portion is 1/4 or less of the 3d transition metal oxide content in the interior, generation of particles can be reduced. If a plurality of 3d transition metal oxides is contained, the sum of the contents of the 3d transition metal oxides is compared between the surface portion and the interior. From the viewpoint of particularly reducing the generation of particles, the 3d transition metal oxide content in the surface portion is preferably 150 ppm or less.

Preferably, the magnesium aluminate-based sintered body of the present embodiment further contains MgNiO₂ crystals. This increases the corrosion resistance to halogen-based corrosive gases and their plasmas relative to the case of not containing MgNiO₂ crystals. The reason why the corrosion resistance is increased is probably that MgNiO₂ crystals are more resistant to halogen-based gases, such as fluorine-based gas, and their plasmas than magnesium aluminate (MgAl₂O₄) crystals of the main crystal phase.

In the magnesium aluminate-based sintered body of the present embodiment, the ratio (I₂/I₁) of the X-ray diffraction peak intensity I₂ of MgNiO₂ crystals at 2θ in the range between 42.5° to 43.5° to the X-ray diffraction peak intensity I₁ of magnesium aluminate at 2θ in the range between 36.8° and 36.9° preferably satisfies the relationship 0.001 ≤ I₂/I₁ ≤ 0.2. In an X-ray diffraction chart, when the ratio (I₂/I₁) of the peak intensity I₂ of MgNiO₂ to the peak intensity I₁ of MgAl₂O₄ of the main crystal phase is within the above range, the amount of MgNiO₂ in the magnesium aluminate-based sintered body can be controlled to an appropriate level. Accordingly, the corrosion resistance can be further increased, and, in addition, the MgNiO₂ crystals in the grain boundaries suppress the grain growth of MgAl₂O₄ forming the main crystal phase, thus helping the formation of a uniform fine crystal structure. Consequently, the degree of densification can also be increased.

The peak intensities of MgAl₂O₄ and MgNiO₂ crystals can be calculated using data of the above-described X-ray diffraction or TEM electron diffraction.

Preferably, the magnesium aluminate-based sintered body of the present embodiment further contains aluminum oxide crystals. Since the aluminum oxide crystals can further increase the strength of the magnesium aluminate-based sintered body, the sintered body can be suitable as a member required to have both high corrosion resistance and high strength, such as a structural member used in an atmosphere in which it will be exposed to a halogen-based corrosive gas or its plasma. In addition, as the amount of aluminum oxide crystals in the magnesium aluminate-based sintered body is increased as a whole, the strength tends to increase.

In the magnesium aluminate-based sintered body of the present embodiment, more preferably, the average grain size of the aluminum oxide crystals is larger than that of the magnesium aluminate crystals. In such a structure, a compressive stress is likely to be applied to the aluminum oxide crystals from the magnesium aluminate crystals at the grain boundaries of the magnesium aluminate crystals of the main crystal phase, and accordingly, grain detachment of the aluminum oxide crystals is unlikely to occur. If such a magnesium aluminate-based sintered body is used as, for example, a member of a semiconductor manufacturing apparatus, particles of detached aluminum oxide crystals are unlikely to be present on the surface of semiconductor wafer or the like, and accordingly, wiring failure and other problems in semiconductor manufacturing processes, caused by contamination with particles can be reduced. Also, the average grain size of the aluminum oxide crystals is preferably in the range of 1.5 to 5 times relative to the average grain size of the magnesium aluminate crystals because such a grain size allows the corrosion resistance to be kept high and suppresses the grain detachment of aluminum oxide crystals.

Whether or not aluminum oxide crystals are present in the magnesium aluminate-based sintered body can be checked by identifying the crystals as described above using X-ray diffraction or TEM electron diffraction.

The method for measuring the average grain sizes of magnesium aluminate crystals and aluminum oxide crystals will now be described.

First, a picture of the surface of a sample is taken at a desired magnification through a scanning electron microscope or the like, and thus image data of magnesium aluminate crystals and aluminum oxide crystals are obtained. Subsequently, distribution data of Mg components and Al components in the same field of view as the image data are obtained using an electron probe microanalyzer (EPMA). The crystals of the image data are each identified using the Mg and Al distribution data. It can be supposed that the crystals of the image date in the region corresponding to the region containing both Mg components and Al components together in the distribution data are magnesium aluminate crystals, and that the crystals of the image data in the region corresponding to the region locally containing Al components in the distribution data are aluminum oxide crystals. Then, the shorter and the longer diameter of the magnesium aluminate crystals and the aluminum oxide crystals are measured, and values of the calculation using the equation: (shorter diameter + longer diameter)/2 are averaged. This measurement is performed at least at 5 points at the surface of the sample, and the measurements are averaged. The average grain sizes of the magnesium aluminate crystals and the aluminum oxide crystals thus can be determined. In this instance, the magnification of the scanning electron microscope or electron probe microanalyzer may be set so that 5 or more crystals of each of magnesium aluminate and magnesium oxide can be observed within the range of a field of view.

An exemplary process for producing the magnesium aluminate-based sintered body of the present embodiment will now be described.

First, starting materials of highly pure magnesium hydroxide (Mg(OH)₂) and aluminum oxide (Al₂O₃), zinc oxide (ZnO) as a Zn source, and potassium hydroxide (KOH) or potassium carbonate (K₂CO₃) as a K source are prepared. These materials are weighed out so that the sum of the elements in terms of ZnO or K₂O will be in the range of 30 ppm to 500 ppm, and then the materials are mixed with pure water and pulverized in a wet manner for 1 to 50 hours in a ball mill containing alumina balls to yield a primary material.

In order to increase the density, or in order to reduce manufacturing cost by reducing the sintering temperature, for example, highly pure silicon oxide (SiO₂), calcium carbonate (CaCO₃) and diphosphorus pentaoxide (P₂O₅) may be prepared as Si, Ca and P sources and be added so that the total content of these elements in terms of SiO₂, CaO or P₂O₅ can be in the range of 500 ppm to 2500 ppm in the magnesium aluminate-based sintered body.

In order to increase the degree of sintering for densification, for example, highly pure titanium oxide (TiO₂), vanadium oxide (V₂O₅), chromium oxide (Cr₂O₃), manganese carbonate (MnCO₃), iron oxide (Fe₂O₃), cobalt oxide (CoO), nickel oxide (NiO), and copper oxide (CuO) may be prepared as 3d transition metal element sources and be added to the primary material. The amount of these materials to be added is preferably in such a range that the total content of 3d transition metal oxides can be not more than 2000 ppm in the magnesium aluminate-based sintered body.

Then, after being dried, the primary material is fired at a temperature in the range of 1100°C to 1300°C for 1 to 10 hours, thereby synthesizing magnesium aluminate from magnesium oxide (Mg(OH)₂) and aluminum oxide (Al₂O₃). Then, the resulting secondary material after being fired is wet-pulverized to an average particle size of 2 µm or less, preferably 1.5 µm or less, in a ball mill or the like. Then, the slurry prepared by wet pulverization is placed in a container. After being dried in a dryer, the material is passed through a mesh to yield a powdered material. The Zn source and the K source may be added when materials are mixed and pulverized to prepare the primary material, or may be added to the powdered material.

In order to allow the magnesium aluminate-based sintered body to contain MgNiO₂ crystals, nickel oxide (NiO) powder is added in a predetermined proportion to the powdered material. As an alternative to nickel oxide (NiO) powder, a sintered body of MgNiO₂ crystals pulverized to a desired particle size may be added to the powdered material. The sintered body is prepared by drying a mixed slurry of a mixture of nickel oxide (NiO) and magnesium hydroxide in a dryer, and heating the dried material at a temperature of 1300°C or more for 1 to 10 hours in an electric furnace.

In order to control the ratio (I₂/I₁) of the X-ray diffraction peak intensity I₂ of MgNiO₂ at 2θ between 42.5° and 43.5°to the X-ray diffraction peak intensity I₁ of magnesium aluminate at 2θ between 36.8° and 36.9° in the range satisfying the relationship 0.001 ≤ I2/I₁ ≤ 0.2 in an X-ray diffraction chart of the surface of the magnesium aluminate-based sintered body, 0.2% to 1.5% by mass of nickel oxide (NiO) powder may be added to 100% by mass of the secondary material containing magnesium hydroxide (Mg(OH)₂) and aluminum oxide (Al₂O₃) in a desired proportion.

In order to allow the magnesium aluminate-based sintered body to further contain aluminum oxide crystals, aluminum oxide (Al₂O₃) powder is added in a predetermined proportion to the above-descried powdered material. In order to allow aluminum oxide crystals to be present independently in the magnesium aluminate-based sintered body, it is important to add aluminum oxide to the powdered material prepared from the secondary material that is the synthesized magnesium aluminate.

Furthermore, in order to allow the aluminum oxide crystals have a larger average grain size than the magnesium aluminate crystal of the main crystals so as not to detach easily, aluminum oxide powder having a larger average particle size than the powdered material may be added. More preferably, aluminum oxide powder having an average particle size of 1.2 times or more of the powdered material is added.

Subsequently, predetermined amounts of pure water and binder are added to the resulting powdered material, and the materials are mixed in a wet manner in a ball mill or the like for a predetermined time. The mixture is subjected to spray granulation with a spray dryer to yield a tertiary material. The tertiary material is formed into a shape by die press forming, cold isostatic press forming, extrusion or the like, thus yielding a compact.

The resulting green body is sintered at a maximum temperature in the range of 1550 °C to 1750 °C for 1 to 10 hours in an air atmosphere, and then, if necessary, subjected to grinding. The magnesium aluminate-based sintered body of the present embodiment is thus completed. For promoting densification, hot isostatic pressing may be applied.

If the magnesium aluminate-based sintered body contains any 3d transition metal element, in order to allow the 3d transition metal oxide content in the surface portion of the magnesium aluminate-based sintered body to be lower than the 3d transition metal oxide content in the interior, the green body is degreased at a maximum temperature in the range of 400°C to 1000°C in an air atmosphere in a furnace. The degreased compact is then placed in a sintering vessel made of carbon and sintered at a maximum temperature in the range of 1550°C to 1750°C for 1 to 10 hours in a furnace evacuated to a vacuum of 10⁻³ to 10⁻⁵ Torr, thus yielding a sintered body. The resulting sintered body is then further subjected to heat treatment at a maximum temperature in the range of 1100°C to 1300°C for a predetermined time in an air atmosphere.

Through the process steps described above, the oxygen (O) of the 3d transition metal oxides in the surface portion of the magnesium aluminate-based sintered body is bound to the carbon of the carbon sintering vessel to form carbon dioxide (CO₂) and is thus removed. Since the boiling point of the residual 3d transition metal elements, from which oxygen has been lost, is considerably reduced relative to the boiling point of their oxides, and accordingly, the 3d transition metal elements are evaporated at the sintering temperature described above, the 3d transition metal oxide content in the surface portion of the magnesium aluminate-based sintered body becomes lower than the 3d transition metal oxide content in the interior.

In order to set the 3d transition metal oxide content in the surface portion to 1/4 or less of the 3d transition metal oxide content in the interior, sintering may be performed at a maximum temperature of 1650°C or more in a furnace evacuated to a vacuum of less than 10⁻⁴ Torr.

If the raw materials of the magnesium aluminate-based sintered body of the present embodiment contain any of the constituents of the sintered body as impurities, it is preferable that the amounts of the raw materials are adjusted in view of the amounts of the constituents contained as impurities so that the content of each constituent of the sintered body can be in the above-mentioned range.

Since the magnesium aluminate-based sintered body of the present embodiment prepared in the above-described process has good corrosion resistance and high strength, it is suitable as a member of a semiconductor manufacturing apparatus, such as a corrosive-resistant member of a chamber (inner wall member), a microwave inlet window, a shower head, a focus ring, or a shielding ring. Also, the sintered body can be used as a component of a cryopump or a turbo molecular pump for increasing the vacuum of a semiconductor apparatus.

An example using the magnesium aluminate-based sintered body of the present embodiment as a member of a semiconductor manufacturing apparatus will now be described with reference to Fig. 1 that is a schematic illustration of an inductively coupled plasma etching apparatus.

The plasma etching apparatus 10 shown in Fig. 1 includes a container 3 including a dome-like upper chamber 1 and a lower chamber 2 in close contact with the upper chamber 1. In the container 3, a support table 4 is placed with an electrostatic chuck 5 thereon. A direct current source (not shown) is connected to an electrode of the electrostatic chuck 5. By supplying electricity to the electrode, semiconductor wafer 6 is electrostatically adsorbed to the upper surface of the electrostatic chuck 5.

The lower chamber 2 is connected to a vacuum pump 9 so that the container 3 can be evacuated to a vacuum. The lower chamber 2 is provided with gas supply nozzles 7 through which an etching gas such as CF₄ gas is introduced. In addition, an induction coil 8 is disposed around the upper chamber 1.

In the plasma etching apparatus 10, first, the container 3 is evacuated to a predetermined vacuum with a vacuum pump 9. Subsequently, the semiconductor wafer 6 is electrostatically adsorbed to the electrostatic chuck 5, and then an etching gas, such as CF₄ gas, is supplied through the gas supply nozzles 7 while electricity is supplied to the induction coil 8 from an RF source. Thus the plasma of the etching gas is formed over the semiconductor wafer 6, and the semiconductor wafer 6 is etched into a predetermined pattern.

Etching gases that can be used as described above include fluorine-based gases that are fluorine compounds, such as SF₆, CF₄, CHF₃, ClF₃, NF₃, C₄F₈, and HF; chlorine-based gases that are chlorine compounds, such as Cl₂, HCl, BCl₃, and CCl₄; and other halogen-based corrosive gases, such as bromine-based gases that are bromine compounds Br₂, HBr, BBr₃, and the like. If the container 3, the support table 4, the electrostatic chuck 5 and other members of the plasma etching apparatus 10 that will be exposed to an halogen-based corrosive gas or its plasma are made of the magnesium aluminate-based sintered body of the present embodiment, these members are corrosion-resistant, dense and strong, and accordingly, can be used for a long time. Also, since the frequency of their replacement and the suspension time of the apparatus for their replacement are thus reduced, the manufacturing cost of semiconductors can be reduced.

The members of a semiconductor manufacturing apparatus, made of the magnesium aluminate-based sintered body of the present embodiment may be those of an apparatus for vapor-phase growth or CVD using a halogen-based corrosive gas or its plasma without being limited to the members of the plasma etching apparatus shown in Fig. 1.

The magnesium aluminate-based sintered body of the present embodiment may be used as a member of an apparatus other than the above-described semiconductor manufacturing apparatuses, such as an apparatus for manufacturing a flat-panel display, such as a liquid crystal display, a plasma display, an organic EL display, or an FED (field emission displays).

### EXAMPLE 1

Samples of the magnesium aluminate-based sintered body were prepared in which the Zn content in terms of ZnO and the K content in terms of K₂O were varied as shown in Table 1. The samples were subjected to measurements for density and three-point flexural strength, and etching rate ratios representing corrosion resistance were calculated. These tests will be described in detail below.

Powders of magnesium hydroxide (Mg(OH)₂), aluminum oxide (Al₂O₃), zinc oxide (ZnO) and potassium hydroxide (KOH) were prepared as starting materials. Subsequently, the powders were weighed out so that the MgAl₂O₄ (MgO:Al₂O₃ = 28.6:71.4 on a mass basis) content and the contents in terms of ZnO or K₂O in the magnesium aluminate-based sintered body could be as shown in Table 1.

Then, the magnesium hydroxide (Mg(OH)₂), aluminum oxide (Al₂O₃), zinc oxide (ZnO) and potassium hydroxide (KOH) weighed out were placed in a ball mill together with pure water and were mixed and pulverized to an average particle size of 1 µm or less in a wet manner using alumina balls, thus yielding a primary material.

After being dried, the primary material was fired at 1200°C for 2 hours to synthesize a secondary material. The secondary material was pulverized to an average particle size of 2 µm or less in a wet manner in a ball mill with alumina balls. Then, the slurry prepared by this wet pulverization was dried in a container. Then, the dried material was passed through a mesh to yield fired powder.

Subsequently, water was added to the fired powder, and the material was mixed in a wet manner in a ball mill with alumina balls. Then, 5% by mass of a binder was added, followed by further mixing. Then, the mixture was subjected to spray granulation with a spray dryer to yield a tertiary material.

Subsequently, the tertiary material was formed into a plate-shaped compact by die press forming. The compact was kept at a sintering temperature of 1650°C in air for 2 hours, thus being sintered. The surfaces of the sintered samples were ground to form samples of the magnesium aluminate-based sintered body numbered 1 to 14, each having a shape of 100 mm in length, 100 mm in width, and 10 mm in thickness.

Each of sample Nos. 1 to 14 was cut into a test piece. The test piece was subjected to measurements for density in accordance with JIS R1634-1998 and three-point flexural strength in accordance with JIS R 1601-1995.

Each sample was also subjected to corrosion resistance test. The sample was cut into a test piece of 10 mm in length, 10 mm in width and 1 mm in thickness. The test piece was set in a RIE apparatus with the surface thereof partially masked, and the test was performed in such a manner that the surface of the test piece was exposed to plasma for 4 hours in a CF₄ gas atmosphere. Then, the level difference between the surface exposed to the plasma and the surface protected by masking from the plasma exposure was measured with a surface roughness meter. The obtained level difference of each sample was compared with the level difference of a 99.5% pure alumina sintered body tested under the same conditions, and the relative value of comparison was evaluated as the etching rate ratio of the sample to the alumina sintered body, whose level difference was defined as 1.

Part of each sample was pulverized into a powder. The powder was dissolved in a solution of, for example, hydrochloric acid and measured with an ICP emission spectrophotometer (ICPS-81 00 manufactured by Shimadzu Corporation). The obtained metal contents of the constituents were calculated into the corresponding oxide contents. It was thus confirmed that the total content of the Mg content in terms of MgO and the Al content in terms of Al₂O₃, and the Zn content in terms of ZnO, and the K content in terms of K₂O coincide with the values shown in Table 1. In Table 1, the sum of the total content of the Mg content in terms of MgO and the Al content in terms of Al₂O₃, and the Zn content in terms of ZnO, and the K content in terms of K₂O do not come to 100% by mass. This is because the magnesium aluminate-based sintered body contains impurities.

The presence of MgAl₂O₄ crystals in each sample was confirmed by X-ray diffraction analysis. Since other large peaks are not observed, the MgAl₂O₄ was considered to be the main crystal phase.

The samples were evaluated as below: when the density of a sample was 3.48 g/cm³, when the three-point flexural strength was 200 MPa or more, and when the etching rate ratio representing corrosion resistance was 0.35 or less, these properties were each determined to be good. The results are shown in Table 1.

**[Table 1]**

| Sample No. | MgAl₂O₃ (mass%) | ZnO (ppm) | K₂O (ppm) | Sum of ZnO and K₂O (ppm) | Density (g/cm³) | Strength (MPa) | Etching rate ratio |
|---|---|---|---|---|---|---|---|
| 1 | 99.7 | 0 | 0 | 0 | 3.42 | 185 | 0.45 |
| 2 | 99.7 | 0 | 60 | 60 | 3.43 | 187 | 0.43 |
| 3 | 99.7 | 30 | 0 | 30 | 3.43 | 186 | 0.43 |
| 4 | 99.7 | 10 | 15 | 25 | 3.45 | 188 | 0.42 |
| 5 | 99.7 | 10 | 20 | 30 | 3.48 | 210 | 0.34 |
| 6 | 99.7 | 30 | 60 | 100 | 3.49 | 254 | 0.33 |
| 7 | 99.7 | 60 | 120 | 180 | 3.50 | 260 | 0.32 |
| 8 | 99.7 | 90 | 180 | 270 | 3.52 | 265 | 0.31 |
| 9 | 99.7 | 120 | 240 | 360 | 3.53 | 270 | 0.33 |
| 10 | 99.7 | 150 | 350 | 500 | 3.52 | 268 | 0.35 |
| 11 | 99.7 | 160 | 360 | 520 | 3.52 | 260 | 0.38 |
| 12 | 99.6 | 90 | 180 | 270 | 3.50 | 245 | 0.35 |
| 13 | 99.8 | 90 | 180 | 270 | 3.52 | 268 | 0.31 |
| 14 | 99.9 | 90 | 180 | 270 | 3.54 | 272 | 0.30 |

As is clear from Table 1, Sample No. 1, which did not contain Zn or K, exhibited a low density, a low three-point flexural strength, and the largest etching rate ratio and accordingly low corrosion resistance. In Sample No.2, which did not contain Zn, Sample No. 3, which did not contain K, and Sample No. 4, which contained Zn and K with a total content of less than 30 ppm in terms of ZnO or K₂O, the effect of increasing density and three-point flexural strength was small, and the effect of increasing corrosion resistance was also small. In Sample No. 11, which contained Zn and K with a total content of more than 500 ppm in terms of ZnO or K₂O, the density and three-point flexural strength were increased, but the etching rate ratio was 0.38, thus showing degraded corrosion resistance.

On the other hand, Sample Nos. 5 to 10 and 12 to 14, which contained MgAl₂O₄ as the main crystal phase; Mg and Al with a total content of 99.7% by mass in terms of MgO or Al₂Oₛ; and Zn and K with a total content in the range of 30 ppm to 500 ppm in terms of ZnO or K₂O, exhibited high densities of 3.48g/cm³ or more, high three-point flexural strengths of 200 MPa or more, and good corrosion resistance with etching rate ratios of 0.35 or less.

For Sample Nos. 8 and 12 to 14, in which the total content of Zn in terms of ZnO and K in terms of K₂O was 270 ppm, the sample Nos. 8, 13 and 14, in which the total content of Mg in terms of MgO and Al in terms of Al₂O₃ was 99.7% or more, exhibited high etching rate ratios of 0.35 or more. This suggests that when the total content of Mg in terms of MgO and Al in terms of Al₂O₃ is 99.7% by mass or more, corrosion resistance tends to further increase.

### EXAMPLE 2

Materials were weighed out so that the Zn content in terms of ZnO and the K content in terms of K₂O could be the same as Sample No.7 in Example 1 and that the total content of Si in terms of SiO₂, Ca in terms of CaO and P in terms of P₂O₅ could coincide with the values shown in Table 2. Thus magnesium aluminate-based sintered bodies were prepared in which the rest of the constituents was MgAl₂O₄ (MgO:Al₂O₃ = 28.6:71.4 in a mass basis). In the preparation of the samples, the steps up to the step of firing were performed in the same manner as in Example 1. The thus prepared compacts were sintered at 1600°C or 1650°C, and the density was measured and the etching rate ratio was calculated. The results are shown in Table 2.

**[Table 2]**

| Sample No. | Sum of Si, Ca and P contents in terms of SiO₂, CaO or P₂O₅ (ppm) | Sintering temperature (°C) | Density (g/cm³) | Etching rate ratio |
|---|---|---|---|---|
| 7 | 0 | 1650 | 3.50 | 0.32 |
| 15 | 100 | 1600 | 3.50 | 0.33 |
| | | 1650 | 3.50 | 0.32 |
| 16 | 500 | 1600 | 3.50 | 0.30 |
| | | 1650 | 3.51 | 0.29 |
| 17 | 1000 | 1600 | 3.51 | 0.29 |
| | | 1650 | 3.52 | 0.28 |
| 18 | 1800 | 1600 | 3.52 | 0.31 |
| | | 1650 | 3.53 | 0.30 |
| 19 | 2500 | 1600 | 3.51 | 0.31 |
| | | 1650 | 3.52 | 0.31 |
| 20 | 2800 | 1600 | 3.50 | 0.34 |
| | | 1650 | 3.50 | 0.33 |

Table 2 shows that sample Nos. 16 to 19, in which the total content of Si in terms of SiO₂, Ca in terms of CaO and P in terms of P₂O₅ was in the range of 500 ppm to 2500 ppm, were able to exhibit increased density and corrosion resistance by being sintered at 1650°C. Also, even in the case of being sintered at a temperature of 1600°C, 50°C lower than the above temperature, the samples exhibited densities and etching rate ratios equaling or surpassing those of Sample No.7. This suggests that if a magnesium aluminate-based sintered body having the same density and corrosion resistance as Sample No. 7 is designed, the manufacturing cost can be reduced.

### EXAMPLE 3

Magnesium aluminate-based sintered bodies having the same Zn content in terms of ZnO and K content in terms of K₂O as Sample No. 7 in Example 1 and containing 3d transition metal oxides were prepared in the following process.

First, Sample No. 21 was prepared in the same manner as in Example 1, except that 3d transition metal oxides were added and that the φ and thickness of the sintered body to be formed was set to 45 mm and 20 mm, respectively. For Sample No. 22, the amount of 3d transition metal elements to be added were set to the same as Sample No. 21, and a compact was formed in the same manner as in Example 1. The resulting compact was first degreased at 1000°C in an air atmosphere in a furnace, and then the degreased compact was placed in a carbon sintering vessel and sintered under the conditions where it was kept at a maximum temperature of 1650°C for 2 hours in a furnace evacuated to a vacuum of 10⁻⁵ Torr. Then, the resulting sintered body was heat-treated at a maximum temperature of 1200°C for 2 hours to yield Sample No. 22.

For Sample Nos. 21 and 22, 5 aliquots to be subjected to measurement were taken from each of the surface portion from the surface of the sample to a depth of 3 mm in the thickness direction and the interior at a depth of 7 mm from the surface in the thickness direction. The aliquot was pulverized into powder, and the powder was dissolved in a hydrochloric acid solution. Then, the metal contents of 3d transition metal elements measured with an ICP emission spectrophotometer (ICPS-81 00 manufactured by Shimadzu Corporation) were calculated into their oxide contents, and the average of the sum of the oxide contents was calculated.

Also, test pieces were cut out in the same manner as in Example 1, and the densities of the test pieces were measured in accordance with JIS R1634-1998.

Also, test pieces of 10 mm in length, 10 mm in width and 1 mm in thickness were cut out from the samples of Nos. 21 and 22, and were subjected to corrosion resistance test in the same manner as in Example 1. After the corrosion resistance test, the test pieces were placed in a container containing pure water. The container containing the test pieces was immersed in a cleaning bath of an ultrasonic washing machine. After the test pieces were taken out, the amount of particles of 0.3 µm or more in the pure water in the container was measured with a particle counter. The results are shown in Table 3.

**[Table 3]**

| Sample No. | Heat treatment method | Portion sampled | Total amount of 3d Transition metal elements in terms of oxides (ppm) | Density (g/cm³) | Amount of particles generated |
|---|---|---|---|---|---|
| 21 | Sintering in ambient atmosphere | Surface portion | 530 | 3.52 | 500 |
| | | Interior | 530 | - | - |
| 22 | Degreasing + sintering in vacuumed atmosphere + heat treatment | Surface portion | 123 | 3.53 | 80 |
| | | Interior | 530 | - | - |

Table 3 shows that both of Sample Nos. 21 and 22 exhibited higher density than the density 3.50 g/cm³ of Sample No. 7, and suggests that densification can be promoted when 3d transition metal oxides are contained. For Sample No. 22, the amount of particles was smaller than that of Sample No. 21. This suggests that it helps reduce the generation of particles to reduce the 3d transition metal oxide content in the surface portion relative to the 3d transition metal oxide content in the interior.

The above Examples suggest that the magnesium aluminate-based sintered body of the present embodiment is superior in corrosion resistance to halogen-based corrosive gases or their plasmas and is dense and strong even without containing rare-earth elements, and accordingly, that it can be suitably used as, for example, a member of a semiconductor manufacturing apparatus. Also, it has been found that a member of a semiconductor manufacturing apparatus made of the magnesium aluminate-based sintered body of the present embodiment having superior characteristics as described above can be used over a long time, and makes it possible to reduce the manufacturing cost of semiconductors because the frequency of the replacement of the members and the suspension time of the apparatus for replacement are reduced.

### EXAMPLE 4

Sample No. 23 of magnesium aluminate-based sintered body containing MgNiO₂ crystals and Sample Nos. 8 and 24 of magnesium aluminate-based sintered body not containing MgNiO₂ crystals were prepared, and these samples were subjected a test for evaluating corrosion resistance.

The compositions of Sample Nos. 23 and 24 were set to be the same that of Sample No. 8 in Example 1, except that a predetermined amount of nickel oxide (NiO) powder previously weighed out was externally added as shown in Table 4. The preparation of sintered bodies was prepared in the same manner as in Example 1, except that nickel oxide (NiO) powder was added to the powdered material prepared after firing the primary material of Example 1 for Sample No. 23, and added to the primary material for Sample No. 24. Sample No. 25 was prepared in the same manner as Sample No.8. The surfaces of the magnesium aluminate-based sintered body samples of Nos. 23 to 25 were measured at 2θ = 10°to 90° under CuKα measurement conditions using an X-ray diffractometer (ADVANCE manufactured by Brukers AXS). The main crystal phases of the samples were identified from the peaks in the obtained X-ray diffraction chart, with reference to JCPDS cards, and Ni-containing crystals other than the crystals of the main crystal phases of the samples were identified. The results are shown in Table 4.

Furthermore, the magnesium aluminate-based sintered body samples of Nos. 8, 23 and 24 were subjected to corrosion resistance test. For the test, the surface of each sample was partially masked. This test piece was set in an RIE apparatus, and the surface of the test piece was exposed to plasma with a power of 140 W and a frequency of 13.56 MHz for 4 hours in an atmosphere of a mixed gas containing CF₄, CH₃ and argon in a proportion of 60:40:20. After the test, the level difference between the surface exposed to the plasma and the surface protected by masking from the plasma exposure was measured with a surface roughness meter. The obtained level difference was compared with the level difference of Sample No. 8, and the relative value of comparison was evaluated as the etching rate ratio of the sample to Sample No. 8, whose level difference was defined as 1.

Part of each sample was pulverized into powder. The powder was dissolved in hydrochloric acid and measured with an ICP emission spectrophotometer (ICPS-81 00 manufactured by Shimadzu Corporation). The obtained metal contents of the constituents were calculated into the corresponding oxide contents. It was thus confirmed that the Ni content in terms of NiO coincides with the value shown in Table 4. The results are shown in Table 4.

**[Table 4]**

| Sample No. | Amount of NiO added (external addition) (mass%) | Presence of MgNiO₂ crystals | Presence of NiAl₂O₄ crystals | Etching rate ratio |
|---|---|---|---|---|
| 23 | 1 | Yes | No | 0.78 |
| 24 | 1 | No | Yes | 0.90 |
| 8 | 0 | No | No | 1.00 |

Table 4 shows that Sample Nos. 23 and 24, which contained Ni, exhibited lower etching rate ratios, 0.90 or less, than Sample No. 8, which did not contain Ni, and thus exhibited more improved corrosion resistance. Furthermore, the etching rate ratio of Sample No. 23, which contained MgNiO₂ crystals, was still lower than that of Sample No. 24, which contained NiAl₂O₄ crystals. This suggests that good corrosion resistance can be achieved by allowing MgNiO₂ crystals to be contained.

### EXAMPLE 5

Samples Nos. 25 to 31 were prepared in the same manner as Sample No. 23 in Example 4, except that the amount of nickel oxide (NiO) externally added to the powdered material prepared after firing the primary material of Example 1 was varied as shown in Table 5 to control the amount of MgNiO₂ crystals in the samples. The samples were subjected to a test for examining the corrosion resistance.

For the amount of MgNiO₂ crystals in Sample Nos. 25 and 26, each sample was subjected to measurement at 2θ = 10°to 90° under CuKα measurement conditions using an X-ray diffractometer (ADVANCE manufactured by Brukers AXS), and crystal phases in the sample were identified from the peaks in the obtained X-ray diffraction chart, with reference to JCPDS cards. Then, the ratio I₂/I₁ of the peak intensity I₂ of MgNiO₂ to the peak intensity I₁ of magnesium aluminate of the main crystal phase was calculated.

Also, the degree of densification of each sample was determined by measuring porosity in accordance with the test method for density (Archimedian method) specified in JIS R 1634-1998, and the etching rate ratio of each sample was obtained relative to Sample No. 8 in the same manner as in Example 4.

Part of each sample was pulverized into powder in the same manner as in Example 1. The powder was dissolved in hydrochloric acid and measured with an ICP emission spectrophotometer (ICPS-81 00 manufactured by Shimadzu Corporation). The obtained metal contents of the constituents were calculated into the corresponding oxide contents. It was thus confirmed that the Ni content in terms of NiO coincides with the value shown in Table 5. The results are shown in Table 5.

**[Table 5]**

| Sample No. | Amount of NiO added (External addition) | Peak intensity ratio I₂/I₁ | Porosity (%) | Etching rate ratio |
|---|---|---|---|---|
| 25 | 0.1 | 0.0005 | 0.01 | 0.86 |
| 26 | 0.2 | 0.001 | 0.01 | 0.82 |
| 27 | 0.5 | 0.04 | 0.02 | 0.76 |
| 28 | 1.0 | 0.10 | 0.02 | 0.78 |
| 29 | 1.2 | 0.14 | 0.05 | 0.80 |
| 30 | 1.5 | 0.20 | 0.10 | 0.85 |
| 31 | 1.6 | 0.22 | 0.12 | 0.88 |

Table 5 shows that Sample Nos. 26 to 30, which exhibited I₂/I₁ peak intensity ratios in the range of 0.001 to 0.2, had porosities of 0.1 % or less and exhibited etching rate ratios of 0.85 or less. Accordingly, it has been found that the corrosion resistance of these samples was higher than that of Sample Nos. 25 and 31, which exhibited peak intensity ratios I₂/I₁ outside the specified range.

### EXAMPLE 6

Sample Nos. 32 to 37 were prepared with the same composition as Sample NO. 8 in Example 1 in the same manner as in Example 1, except that aluminum oxide (Al₂O₃) powder having an average particle size shown in Table 6 was externally added to the powdered material prepared by pulverizing the fired primary material of the magnesium aluminate-based sintered body to an average particle size shown in Table 6. The Al₂O₃ powder was added in such a proportion of 0.2% by mass relative to 100% by mass of the magnesium aluminate-based sintered body after being fired.

The surface of each sample was mirror-polished, and scanning electron micrographs of the polished surfaces were taken to obtain image data of magnesium aluminate crystals and Al₂O₃ crystals. Subsequently, distribution data of Mg components and Al components in the same field of view as the above image data were obtained by measuring the samples with an electron probe microanalyzer (EPMA) at an acceleration voltage of 15 kV, an irradiation current of 2.0 x 10⁻⁷ A, and an irradiation time of 30 ms. Using the distribution data, it was identified whether the crystals in the image data were magnesium aluminate crystals or Al₂O₃ crystals. Then, the shorter and the longer diameter of the identified crystals were measured, and values of the calculation using the equation: (shorter diameter + longer diameter)/2 were averaged. This measurement was performed at least at 5 points at the surface of each sample, and the measured values were averaged. The average grain sizes of the magnesium aluminate crystals and the Al₂O₃ crystals were thus determined.

Three-point flexural strengths of Sample Nos. 32 to 37 were measured in the same manner as in Example 1.

Furthermore, the amounts of particles of Sample Nos. 32 to 37 were measured in the same manner as in Example 3.

Part of each sample in Table 6 was pulverized into powder. The powder was dissolved in hydrochloric acid and measured with an ICP emission spectrophotometer (ICPS-81 00 manufactured by Shimadzu Corporation). The obtained metal contents of the constituents were calculated into the corresponding oxide contents, and the Al content in terms of Al₂O₃ was measured. As a result, it was confirmed that the Al content of each sample was 0.2% by mass increased relative to Sample No.8 in Example 1.

The results are shown in Table 6.

**[Table 6]**

| Sample No. | Average particle size of powdered material (µm) | Average particle size of Al₂O₃ powder (µm) | Average grain size of magnesium aluminate crystals (µm) | Average grain size of Al₂O₃ crystals (µm) | Strength (MPa) | Amount of particles generated |
|---|---|---|---|---|---|---|
| 32 | 1 | 2 | 8 | 7 | 270 | 78 |
| 33 | 1 | 3.0 | 8 | 10 | 285 | 72 |
| 34 | 1 | 5.0 | 8 | 12 | 292 | 65 |
| 35 | 1 | 10.0 | 8 | 15 | 300 | 60 |
| 36 | 1 | 30.0 | 8 | 24 | 295 | 53 |
| 37 | 1 | 50.0 | 8 | 30 | 288 | 45 |

The results in Table 6 show that Sample Nos. 32 to 37, in which Al₂O₃ crystals were present, exhibited three-point flexural strengths of 270 MPa or more, that is, exhibited higher strengths than Sample No. 8 in Example 1, in which Al₂O₃ crystals were not present. Thus, it has been found that the strength of the magnesium aluminate-based sintered body can be increased by allowing aluminum oxide crystals to be present in the magnesium aluminate-based sintered body.

Also, Sample Nos. 33 to 37, in which the average grain size of Al₂O₃ crystals was larger than that of magnesium aluminate crystals, exhibited strengths of 285 Mpa or more, and the amount of particles was as small as 72 or less. Accordingly, it has been found that such samples can reduce the amount of particles more than Sample No. 32, in which the average grain size of Al₂O₃ crystals was smaller than that of magnesium aluminate crystals.

### REFERENCE SIGNS LIST

- 1:: upper chamber
- 2:: lower chamber
- 3:: container
- 4:: support table
- 5:: electrostatic chuck
- 6:: semiconductor wafer
- 7:: gas supply nozzle
- 8:: induction coil
- 9:: vacuum pump

## Claims

1. A magnesium aluminate-based sintered body, containing:
magnesium aluminate as a main crystal phase; and
Zn and K, wherein a sum of Zn content in terms of ZnO and K content in terms of K₂O is in a range of 30 ppm to 500 ppm relative to a total mass of oxides calculated from contents of all constituents.

2. The magnesium aluminate-based sintered body according to claim 1, containing Si, Ca, and P, wherein a sum of the Si content in terms of SiO₂, Ca content in terms of CaO and P content in terms of P₂O₅ is in a range of 500 ppm to 2500 ppm relative to the total mass of oxides calculated from the content of all constituents.

3. The magnesium aluminate-based sintered body according to claim 1 or 2, containing a 3d transition metal oxide, wherein 3d transition metal oxide content in a surface portion thereof is lower than 3d transition metal oxide content in the interior portion thereof.

4. The magnesium aluminate-based sintered body according to claim 3, wherein the 3d transition metal oxide content in the surface portion is 1/4 or less of the 3d transition metal oxide content in the interior portion.

5. The magnesium aluminate-based sintered body according to claim 1 or 2, containing MgNiO₂ crystals.

6. The magnesium aluminate-based sintered body according to claim 5, wherein a peak intensity ratio (I₂/I₁) of the X-ray diffraction peak intensity I₂ of the MgNiO₂ crystals at 2θ = 42.5° ~ 43.5 ° to the X-ray diffraction peak intensity I₁ of the magnesium aluminate at 2θ = 36.8° ~ 36.9° is 0.001 ≤ I2/I₁ ≤ 0.2.

7. The magnesium aluminate-based sintered body according to any one of claims 1 to 6, containing aluminum oxide crystals.

8. The magnesium aluminate-based sintered body according to claim 7, wherein an average grain size of the aluminum oxide crystals is larger than an average grain size of the magnesium aluminate crystals.

9. A member for a semiconductor manufacturing apparatus, composed of the magnesium aluminate-based sintered body according to any one of claims 1 to 8.
